# FASCICULE DE BREVET EUROPEEN

(11) **EP 4 450 983 B1**
(45) Date de publication et mention de la délivrance du brevet: **19.11.2025**
(21) Numéro de dépôt: 24164434.3
(22) Date de dépôt: 19.03.2024
(51) Int. Cl.: G01R 27/18

(54) **PROCÉDÉ DE MESURE ET OHMMÈTRE DE BOUCLE MONO-TORE À COMPENSATION DE FLUX DE FUITE DC**
EINTOR-SCHLEIFEN-MESSVERFAHREN UND -METER MIT DC-LECKSTROMKOMPENSATION
DC LEAKAGE FLUX COMPENSATED MONO-TORE LOOP OHMIC METER AND MEASUREMENT METHOD

(30) Priorité: 29.03.2023 FR 2303022
(43) Date de publication de la demande: 23.10.2024
(73) Titulaire: Chauvin Arnoux, 92600 Asnieres-sur-Seine (FR)
(72) Inventeur: ADAM, Jérôme, 92600 ASNIERES-SUR-SEINE (FR); LEGROS, Philippe, 92600 ASNIERES-SUR-SEINE (FR)
(74) Mandataire: Cabinet Beau de Loménie

(56) Documents cités:
- EP-A1- 1 566 644
- CN-A- 114 720 744
- CN-B- 110 007 133
- CN-B- 110 824 229
- FR-A1- 2 824 951
- FR-A1- 2 985 032
- IT-A1- PD20 090 005
- JP-A- 2001 066 329
- US-A1- 2014 021 939

## Description

### Domaine Technique

La présente invention se rapporte au domaine du contrôle des installations électriques et elle concerne plus particulièrement la mesure de résistances de terre au moyen d'ohmmètres de boucle.

### Technique antérieure

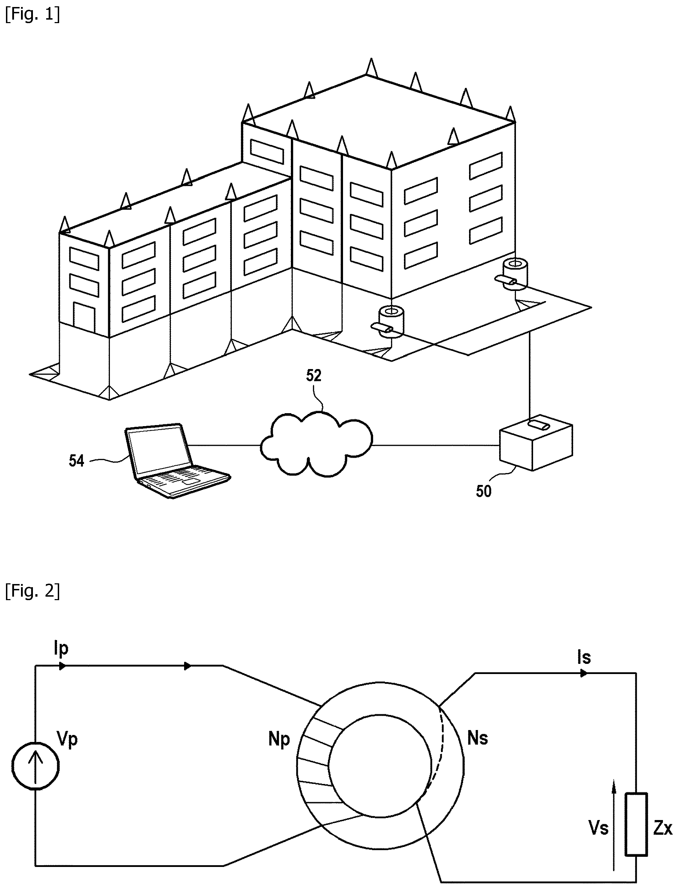

Les ohmmètres de boucle sont des appareils destinés à contrôler la conformité des raccordements à la terre d'installations électriques ou de bâtiments comme celui illustré à la figure 1. Ils sont particulièrement appropriés lorsque l'installation électrique dispose de multiples mises à la terre en parallèle formant plusieurs boucles de terre successives car la mesure ne nécessite pas de planter dans la terre des piquets auxiliaires ou d'ouvrir une liaison à la terre (barrette de terre par exemple) pour isoler l'installation électrique.

Classiquement, les ohmmètres de boucle recourent à l'utilisation de deux transformateurs magnétiquement isolés l'un de l'autre et enserrant le conducteur de raccordement à la terre, l'un pour injecter une tension par induction et l'autre pour mesurer le courant circulant dans la boucle. L'impédance du raccordement à la terre est alors déduite du rapport entre cette tension et le courant mesuré.

Toutefois, et comme le montre la figure 2, il est connu par le brevet EP1 566 644 B1 déposé au nom de la demanderesse un ohmmètre de boucle mono-tore qui permet de s'affranchir du transformateur de courant et de l'isolation magnétique entre les deux transformateurs en ne faisant appel qu'à un seul transformateur constitué d'un tore avec un enroulement primaire Np, utilisé simultanément pour l'injection de la tension et la mesure du courant circulant dans la boucle de terre, et un enroulement secondaire Ns avec une spire unique formé par le conducteur de raccordement à la terre et dont l'impédance de boucle Zx est à mesurer. L'application d'une tension de consigne Vp aux bornes du primaire du transformateur fait circuler dans ce primaire un courant de mesure Ip qui induit, dans le conducteur enserré formant le secondaire, la tension secondaire Vs engendrant le courant secondaire Is = Vs / Zx circulant dans la boucle, m étant le rapport des nombres de tours de l'enroulement secondaire Ns et de l'enroulement primaire Np, soit m = Ns/Np.

Etant donné que la tension appliquée aux bornes du primaire Vp est une grandeur connue, si le transformateur était un transformateur parfait, il suffirait de mesurer le courant primaire Ip pour connaître l'impédance Zx. Mais, dans la réalité, le transformateur n'est pas parfait et a des pertes de flux magnétique, des pertes fer et cuivre et une perméabilité de circuit magnétique finie.

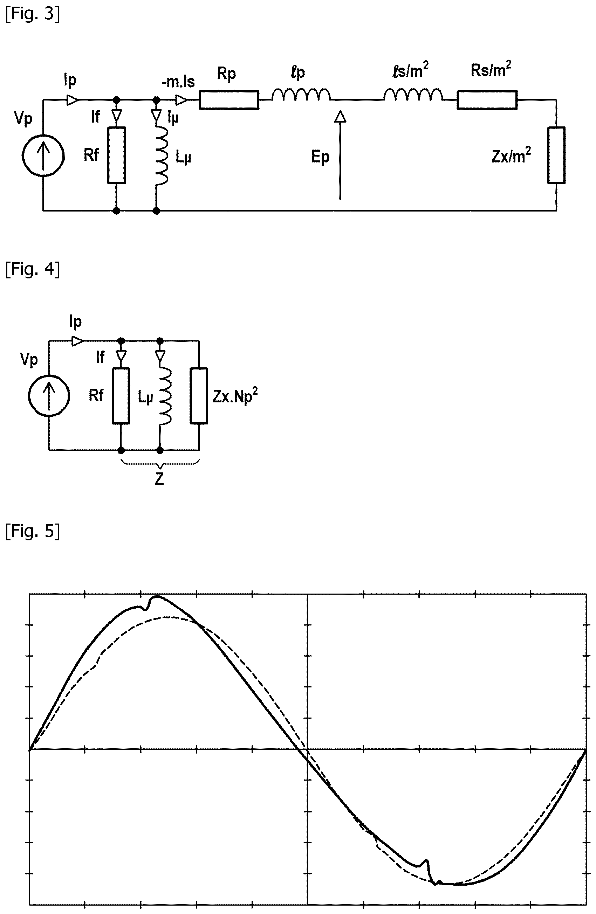

Aussi, la figure 3 illustre le schéma électrique équivalent du transformateur réel ramené au primaire sur lequel, Rf représente la résistance équivalente aux pertes fer du transformateur, Lµ l'inductance magnétisante du transformateur, c'est-à-dire l'image de la perméabilité non infinie du circuit magnétique, If et Iµ les composantes du courant magnétisant du transformateur, Rp la résistance de l'enroulement primaire, c'est-à-dire l'image des pertes cuivre, Ip l'inductance de fuite du primaire, c'est-à-dire l'image des pertes de flux magnétique, Rs la résistance de l'enroulement secondaire, Is l'inductance de fuite du secondaire et Ep la tension réelle générant le flux magnétique du transformateur.

Ce schéma équivalent peut se simplifier compte tenu que l'enroulement Ns étant constitué par la boucle dont on veut mesurer l'impédance Zx, il en résulte donc que Ns = 1 et Is devient négligeable et peut être considéré comme étant égal à zéro, de même que Rs, et que la valeur de Rp est négligeable devant ZxNp² d'où Rp ≈ 0.

Le schéma équivalent se réduit donc à la forme simplifiée illustrée sur la figure 4, ce qui permet d'écrire : Ip/Vp = 1/Z = 1/Rf + 1/jLµω + 1/ZxNp²

Où ω = 2nf, f étant la fréquence de la tension de consigne Vp.

La méthode de mesure d'impédance de boucle décrite ci-dessus nécessite donc une connaissance permanente des valeurs de Rf et Lµ pour déterminer Zx. Ces deux valeurs sont obtenues à vide (boucle ouverte) avant l'installation du tore du transformateur autour de la boucle dont l'impédance Zx est à mesurer.

Or, ces valeurs évoluent en fonction du niveau d'induction dans le tore qui dépend de la présence des courants parasites AC et DC circulant dans la boucle de mesure et qui doivent donc être compensés pour que les valeurs restent exploitables durant la phase de mesure et garantissent la précision de mesure recherchée sur la plage de mesure souhaitée.

### Exposé de l'invention

La présente invention a pour but principal de réduire l'influence de l'induction dans le tore (et principalement sur les pertes fer dont Rf est le modèle électrique) due à la présence de courant continu parasite DC dans la boucle de mesure.

Ce but est atteint par un procédé de mesure d'une impédance de boucle Zx dans un ohmmètre mono-tore comportant un transformateur unique ayant un enroulement primaire de Np spires et un enroulement secondaire d'une spire unique formant une boucle de mesure d'impédance Zx, caractérisé en ce que, pour compenser un courant de fuite DC circulant dans la boucle de mesure sans annuler un courant de mesure Ip générant une induction alternative de valeur moyenne constante pour la mesure de l'impédance de boucle Zx, ledit courant de mesure Ip est additionné à un courant constant opposé et proportionnel à l'induction parasite produite par le courant de fuite DC, pour être réinjecté dans l'enroulement primaire.

Cette induction parasite peut être mesurée par différents procédés comme un capteur à effet hall ou fluxgate ou une boucle de Rogowski, mais selon une réalisation avantageuse, la mesure de l'induction parasite est issue d'une tension de sortie Ub délivrée aux bornes d'un second enroulement secondaire de Na spires du transformateur unique et tout d'abord intégrée puis objet successivement d'une comparaison avec un seuil déterminé et d'un filtrage passe-bas.

Ainsi, en mesurant, par quelque moyen que ce soit et de préférence au moyen d'un second enroulement secondaire, une grandeur dont l'amplitude est corrélée à une composante continue de l'induction résultant d'un courant de fuite DC, et en compensant les champs magnétiques associés en injectant un courant DC dans le primaire, on réduit l'influence de ce courant de fuite DC circulant dans la boucle de mesure sur les pertes fer.

Avantageusement, la comparaison consiste à déterminer la durée pendant laquelle la tension de sortie Ub est positive et la durée pendant laquelle elle est négative.

L'invention concerne également un ohmmètre de boucle mono-tore mettant en œuvre le procédé précité.

Selon le mode de réalisation envisagé, le module de traitement de la tension de sortie du second enroulement secondaire peut consister en un intégrateur suivi d'un comparateur avec un seuil déterminé et d'un filtre passe-bas, le convertisseur tension-courant et la valeur de la résistance de shunt étant choisis de sorte que le nombre d'ampères-tours fournis par l'enroulement primaire à un noyau magnétique du transformateur unique soit égal au nombre d'ampères-tours fourni à ce noyau magnétique par l'enroulement secondaire à spire unique, ou encore, le module de traitement de la tension de sortie du second enroulement secondaire peut consister en un intégrateur suivi d'un comparateur avec un seuil déterminé et d'un filtre passe-bas dont la tension de sortie est corrigée dans un module de correction numérique.

Avantageusement, le module de correction numérique consiste en un microcontrôleur précédé d'un convertisseur analogique-numérique et suivi par un convertisseur numérique analogique.

De préférence, le comparateur est configuré pour déterminer la durée pendant laquelle la tension de sortie Ub est positive et la durée pendant laquelle elle est négative.

Avantageusement, le rapport entre le nombre de spires Np de l'enroulement primaire et le nombre de spires Na du second enroulement secondaire est égal à un.

De préférence, le transformateur est réalisé sous la forme d'un capteur magnétique non-ouvrant laissé à demeure sur un conducteur de raccordement à la terre et l'impédance de boucle Zx est transmise périodiquement à un serveur distant via au moins un réseau de communication.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur lesquels :
[Fig. 1] la figure 1 montre un ensemble de lignes électriques comportant des prises de terre reliant entre eux divers bâtiments,
[Fig. 2] la figure 2 montre schématiquement un ohmmètre de boucle mono-tore,
[Fig. 3] la figure 3 montre le schéma électrique équivalent d'un transformateur réel ramené au primaire,
[Fig. 4] la figure 4 montre le schéma simplifié du transformateur de la figure 3,
[Fig.5] la figure 5 montre deux courbes de la tension aux bornes du second enroulement secondaire du transformateur,
[Fig.6] la figure 6 est un schéma de principe d'un ohmmètre de boucle mono-tore à compensation de flux de fuite DC selon l'invention, et
[Fig.7] la figure 7 est un schéma de principe d'un ohmmètre de boucle mono-tore à compensation de flux de fuite DC dans le cas d'un traitement uniquement analogique.

### Description des modes de réalisation

Le principe de l'invention repose sur une mesure de l'induction à l'aide d'un second enroulement secondaire pour compenser son influence sur Rf et Lµ. En utilisant ce second enroulement secondaire dont la tension en sortie est la dérivée du flux magnétique comme indicateur du flux DC, un courant proportionnel est réinjecté dans l'enroulement primaire pour compenser ce flux DC perturbateur créé par le courant à mesurer circulant dans la boucle de mesure, sans avoir à interrompre la mesure.

Or, comme le montre la figure 5, le passage d'un courant DC à travers un tore (l'élément ferromagnétique du transformateur) de forte perméabilité, le polarise et déforme le cycle d'hystérésis. Il en résulte qu'un signal sinusoïdal circulant dans un enroulement primaire, n'est pas parfaitement reproduit dans un enroulement secondaire, en particulier la durée pendant laquelle le signal de l'enroulement secondaire est positif est différente de la durée pendant laquelle il est négatif. Ainsi, sur la figure montrant le signal observé aux bornes de cet enroulement secondaire, la courbe en pointillé correspond au cas où le courant de fuite DC est nul et montre une tension de l'enroulement secondaire parfaitement sinusoïdale, et la courbe en trait plein correspond à la présence d'un courant de fuite DC au travers du tore et montre une tension de l'enroulement secondaire déformée en amplitude et ne passant pas par le point central du relevé. En particulier, la durée de la partie positive de la tension est plus courte que la durée de sa partie négative.

En s'appuyant sur ce constat, l'invention propose de comparer la durée de l'alternance positive à la durée de l'alternance négative du signal prélevé au second enroulement secondaire pour assurer une compensation du courant continu parasite circulant dans la boucle de mesure (ci-après courant de fuite DC).

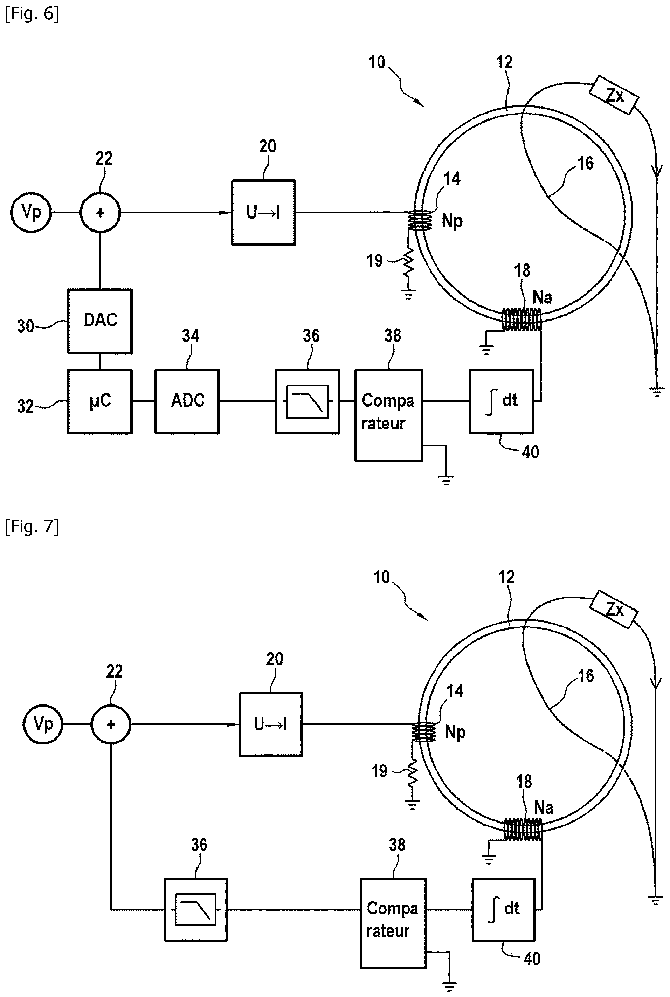

La figure 6 illustre un premier schéma de principe de cette compensation effectuée dans l'ohmmètre de boucle mono-tore de l'invention.

Le transformateur 10 est illustré par son tore (le noyau magnétique 12), l'enroulement primaire 14 de Np spires, l'enroulement secondaire 16 à spire unique Ns formé par la boucle de mesure de l'impédance Zx et le second enroulement secondaire 18 de Na spires. De préférence, le rapport entre les nombres de spires à l'enroulement primaire Np et au second enroulement secondaire Na est égal à un sans que ce rapport ne soit limitatif (ce rapport pouvant être supérieur ou inférieur à 1). Le courant injecté dans l'enroulement primaire 14 et dont l'amplitude est fixée par une résistance de shunt 19 est issu d'un convertisseur tension-courant 20, typiquement à amplificateur opérationnel, recevant la sortie d'un additionneur 22 destiné à ajouter un signal de compensation (destiné à créer une induction alternative de valeur moyenne constante dans le tore) au signal de mesure et recevant donc d'une part la tension alternative de mesure Vp correspondant à la tension utile pour mesurer Zx et d'autre part une tension Ucomp qui correspond à l'asservissement mis en place pour compenser le courant de fuite DC, et qui est prise en sortie d'un convertisseur numérique analogique (DAC 30) piloté depuis un microcontrôleur 32 précédé d'un convertisseur analogique-numérique (ADC 34) dont l'entrée est prise en sortie d'un filtre passe-bas 36 précédé lui-même d'un comparateur 38 dont l'entrée est reliée à un intégrateur 40 nécessaire pour obtenir un signal représentant l'induction dans le tore, c'est-à-dire retrouver un courant constant opposé au courant de fuite DC et représentant le champ magnétique issu de ce courant de fuite DC et prélevé aux bornes du second enroulement secondaire 18. Le comparateur à seuil déterminé permet de comparer la durée pendant laquelle la tension de sortie Ub est positive et la durée pendant laquelle elle est négative, c'est à dire les périodes où l'induction dans le noyau magnétique (le tore) est supérieure à 0 et celle où elle est inférieure à 0.

L'ensemble des DAC 30, microcontrôleur 32 et ADC 34 forme un module de correction numérique qui associé aux intégrateur 40, comparateur 38 et filtre passe-bas 36, constitue un module de traitement de la tension de sortie Ub.

Le microcontrôleur 32 enregistre et mémorise une (ou avantageusement plusieurs valeurs) de la mesure intégrée (valeur monotone et pas directement proportionnelle à l'induction DC) de la sortie du comparateur en l'absence de courant de fuite : pour une boucle ouverte, et avantageusement pour une ou plusieurs boucles fermées sur une impédance connue. Ces valeurs permettent de définir une consigne d'asservissement qui modifie le courant généré pour que la mesure de la moyenne des valeurs relevées converge vers la consigne.

La figure 7 illustre un second schéma de principe de la compensation effectuée dans l'ohmmètre de boucle mono-tore dans le cas de l'utilisation d'un traitement uniquement analogique au lieu d'un traitement mixte à la fois analogique et numérique.

Dans cette configuration, l'additionneur reçoit directement le courant de compensation analogique issu du filtre passe-bas et le convertisseur tension-courant 20 ainsi que la valeur de la résistance de shunt 19 sont alors choisis tel que le nombre d'ampères-tours fournis par l'enroulement 14 au noyau magnétique 12 soit égal au nombre d'ampères-tours fourni à ce noyau magnétique par l'enroulement unique 16. Ainsi, en s'assurant que le sens de circulation du courant dans les enroulements 14 et 16 soit opposé l'un à l'autre, le flux magnétique continu couplé au noyau magnétique 12 par l'enroulement unique 16 est annulé par le flux magnétique continu couplé au noyau magnétique 12 par l'enroulement 14.

Laissé à demeure sur un conducteur de raccordement à la terre, c'est dire avec un transformateur formant un capteur magnétique non-ouvrant, l'ohmmètre de boucle selon l'invention peut surveiller en permanence l'impédance de boucle Zx, et donc l'impédance de terre synonyme de qualité de la protection au point d'installation de ce capteur.

Comme le montre la figure 1, il peut comporter des moyens de communication propres en liaison via un réseau de communication (avantageusement sans fil de type 3G-5G ou Wifi notamment) ou filaire (Ethernet notamment) avec les moyens correspondant de communication d'un boitier local de mesure 50 pour transmettre régulièrement ses mesures d'impédance à un serveur distant 52 via le réseau Internet 54 par exemple, évitant ainsi le déplacement d'un opérateur pour assurer le contrôle de l'impédance Zx.

Avec l'invention, le courant de fuite DC est compensé sans annuler le courant de mesure injecté pour la mesure de l'impédance de boucle Zx. En effet, le courant de mesure Ip destiné à être injecté sur l'enroulement primaire Np ne doit pas être impacté par l'asservissement du courant de fuite DC, d'où la présence du filtrage passe-bas dans le signal de compensation du courant de fuite DC pour que cette compensation n'annule pas le courant de mesure.

## Revendications

1. Procédé de mesure d'une impédance de boucle Zx dans un ohmmètre mono-tore comportant un transformateur unique ayant un enroulement primaire de Np spires (14) et un enroulement secondaire d'une spire unique (16) formant une boucle de mesure d'impédance Zx, **caractérisé en ce que**, pour compenser une induction parasite produite par un courant de fuite DC circulant dans la boucle de mesure sans annuler un courant de mesure Ip générant une induction alternative de valeur moyenne constante pour la mesure de l'impédance de boucle Zx, ledit courant de mesure Ip est additionné à un courant constant opposé et proportionnel à l'induction parasite produite par le courant de fuite DC, pour être réinjecté dans l'enroulement primaire.

2. Procédé de mesure d'une impédance de boucle Zx selon la revendication 1, dans lequel la mesure de l'induction parasite est issue d'une tension de sortie Ub prélevée aux bornes d'un second enroulement secondaire de Na spires du transformateur unique et tout d'abord intégrée puis objet successivement d'une comparaison avec un seuil déterminé et d'un filtrage passe-bas.

3. Procédé de mesure d'une impédance de boucle Zx selon la revendication 1 ou la revendication 2, dans lequel la comparaison consiste à déterminer la durée pendant laquelle la tension de sortie Ub est positive et la durée pendant laquelle elle est négative.

4. Ohmmètre mono-tore de mesure d'une impédance de boucle Zx, comportant un transformateur unique ayant un enroulement primaire de Np spires (14) et un enroulement secondaire d'une spire unique (16) formant une boucle de mesure d'impédance Zx, **caractérisé en ce que** pour compenser une induction parasite produite par un courant de fuite DC circulant dans la boucle de mesure sans annuler un courant de mesure Ip générant une induction alternative de valeur moyenne constante pour la mesure de l'impédance de boucle Zx, le transformateur comporte un second enroulement secondaire de Na spires (18) dont la tension de sortie Ub est délivrée à un module de traitement (30 - 40) fournissant une tension destinée à être additionnée à une tension alternative de mesure Vp dans un additionneur (22) délivrant le courant à injecter dans l'enroulement primaire (14) après passage dans un convertisseur tension-courant (20) alimentant en courant l'enroulement primaire via une résistance de shunt (19).

5. Ohmmètre mono-tore selon la revendication 4, dans lequel le module de traitement de la tension de sortie du second enroulement secondaire (18) consiste en un intégrateur (40) suivi d'un comparateur avec un seuil déterminé (38) et d'un filtre passe-bas (36), le convertisseur tension-courant (20) et la valeur de la résistance de shunt (19) étant choisis de sorte que le nombre d'ampères-tours fournis par l'enroulement primaire (14) à un noyau magnétique (12) du transformateur unique soit égal au nombre d'ampères-tours fourni à ce noyau magnétique par l'enroulement secondaire à spire unique (16).

6. Ohmmètre mono-tore selon la revendication 4, dans lequel le module de traitement de la tension de sortie du second enroulement secondaire (18) consiste en un intégrateur (40) suivi d'un comparateur avec un seuil déterminé (38) et d'un filtre passe-bas (36) dont la tension de sortie est corrigée dans un module de correction numérique (30, 32, 34).

7. Ohmmètre mono-tore selon la revendication 6, dans lequel le module de correction numérique consiste en un microcontrôleur (32) précédé d'un convertisseur analogique-numérique (ADC 34) et suivi par un convertisseur numérique analogique (DAC 30).

8. Ohmmètre mono-tore selon la revendication 5 ou la revendication 6, dans lequel le comparateur est configuré pour déterminer la durée pendant laquelle la tension de sortie Ub est positive et la durée pendant laquelle elle est négative.

9. Ohmmètre mono-tore selon l'une quelconque des revendications 4 à 8, dans lequel le rapport entre le nombre de spires Np de l'enroulement primaire (14) et le nombre de spires Na du second enroulement secondaire (18) est égal à un.

10. Ohmmètre mono-tore selon l'une quelconque des revendications 4 à 9, dans lequel le transformateur est réalisé sous la forme d'un capteur magnétique non-ouvrant laissé à demeure sur un conducteur de raccordement à la terre et l'impédance de boucle Zx est transmise périodiquement à un serveur (54) distant via au moins un réseau de communication (52).

## Patentansprüche

1. Verfahren zum Messen einer Schleifenimpedanz Zx in einem Ohmmeter mit einem Ringkern, das einen einzigen Transformator umfasst, der eine Primärwicklung aus Np Windungen (14) und eine Sekundärwicklung aus einer einzigen Windung (16) aufweist, die eine Impedanzmessschleife Zx bildet, **dadurch gekennzeichnet, dass** zum Kompensieren einer Störinduktion, die von einem Wechselleckstrom erzeugt wird, der in der Messchleife fließt, ohne Aufheben eines Messstroms Ip, der eine Wechselinduktion mit konstantem Mittelwert zur Messung der Schleifenimpedanz Zx erzeugt, der Messstrom Ip zu einem Konstantstrom addiert wird, der entgegengesetzt und proportional zu der Störinduktion ist, die von dem Wechselleckstrom erzeugt wird, um erneut in die Primärwicklung eingespeist zu werden.

2. Verfahren zum Messen einer Schleifenimpedanz Zx nach Anspruch 1, wobei die Messung der Störinduktion von einer Ausgangsspannung Ub stammt, die an den Anschlüssen einer zweiten Sekundärwicklung mit Na Windungen des einzigen Transformators abgegriffen wurde und zuallererst integriert und dann aufeinanderfolgend einem Vergleich mit einem bestimmten Schwellenwert und einer Tiefpassfilterung unterzogen wurde.

3. Verfahren zum Messen einer Schleifenimpedanz Zx nach Anspruch 1 oder Anspruch 2, wobei der Vergleich darin besteht, die Dauer, während der die Ausgangsspannung Ub positiv ist, und die Dauer zu bestimmen, während der sie negativ ist.

4. Ohmmeter mit einem Ringkern zum Messen einer Schleifenimpedanz Zx, das einen einzigen Transformator umfasst, der eine Primärwicklung aus Np Windungen (14) und eine Sekundärwicklung aus einer einzigen Windung (16) aufweist, die eine Impedanzmessschleife Zx bildet, **dadurch gekennzeichnet, dass** zum Kompensieren einer Störinduktion, die von einem Wechselleckstrom erzeugt wird, der in der Messchleife fließt, ohne Aufheben eines Messstroms Ip, der eine Wechselinduktion mit konstantem Mittelwert zur Messung der Schleifenimpedanz Zx erzeugt, der Transformator eine zweite Sekundärwicklung mit Na Windungen (18) umfasst, dessen Ausgangsspannung Ub an ein Verarbeitungsmodul (30 - 40) abgegeben wird, das eine Spannung liefert, die dazu bestimmt ist, zu einer Messwechselspannung Vp in einem Addierer (22) addiert zu werden, der den Strom liefert, der nach dem Durchqueren eines Spannung-Strom-Wandlers (20), der die Primärwicklung über einen Shunt-Widerstand (19) mit Strom versorgt, in die Primärwicklung (14) einzuspeisen ist.

5. Ohmmeter mit einem Ringkern nach Anspruch 4, wobei das Modul zur Verarbeitung der Ausgangsspannung der zweiten Sekundärwicklung (18) aus einem Integrator (40), gefolgt von einem Komparator mit einem bestimmten Schwellenwert (38) und einem Tiefpassfilter (36) besteht, wobei der Spannung-Strom-Wandler (20) und der Wert des Shunt-Widerstands (19) derart gewählt werden, dass die Anzahl der Amperewindungen, die von der Primärwicklung (14) einem Magnetkern (12) des einzigen Transformators bereitgestellt werden, gleich der Anzahl der Amperewindungen ist, die diesem Magnetkern von der Sekundärwicklung mit einer einzigen Windung (16) bereitgestellt wird.

6. Ohmmeter mit einem Ringkern nach Anspruch 4, wobei das Modul zur Verarbeitung der Ausgangsspannung der zweiten Sekundärwicklung (18) aus einem Integrator (40), gefolgt von einem Komparator mit einem bestimmten Schwellenwert (38) und einem Tiefpassfilter (36) besteht, dessen Ausgangsspannung in einem digitalen Korrekturmodul (30, 32, 34) korrigiert wird.

7. Ohmmeter mit einem Ringkern nach Anspruch 6, wobei das digitale Korrekturmodul aus einem Mikrocontroller (32) besteht, dem ein Analog-Digital-Wandler (ADC 34) vorausgeht und auf den ein Digital-AnalogWandler (DAC 30) folgt.

8. Ohmmeter mit einem Ringkern nach Anspruch 5 oder Anspruch 6, wobei der Komparator dazu ausgestaltet ist, die Dauer, während der die Ausgangsspannung Ub positiv ist, und die Dauer zu bestimmen, während der sie negativ ist.

9. Ohmmeter mit einem Ringkern nach einem der Ansprüche 4 bis 8, wobei das Verhältnis zwischen der Anzahl der Windungen Np der Primärwicklung (14) und der Anzahl der Windungen Na der zweiten Sekundärwicklung (18) gleich eins ist.

10. Ohmmeter mit einem Ringkern nach einem der Ansprüche 4 bis 9, wobei der Transformator in der Form eines nicht öffnenden Magnetsensors ausgeführt ist, der auf einem Leiter zum Anschluss an die Erde belassen wird, und die Schleifenimpedanz Zx periodisch über mindestens ein Kommunikationsnetzwerk (52) an einen entfernten Server (54) übermittelt wird.

## Claims

1. A method for measuring a loop impedance Zx in a single-torus ohmmeter including a single transformer having a primary winding of Np coils (14) and a secondary winding of a single coil (16) forming a measurement loop of impedance Zx, **characterized in that**, to compensate for a stray induction produced by a DC leakage current circulating in the measurement loop without canceling a measurement current Ip generating an alternating induction of constant average value for the measurement of the loop impedance Zx, said measurement current Ip is added to a constant current opposite and proportional to the stray induction produced by the DC leakage current, to be re-injected into the primary winding.

2. The method for measuring a loop impedance Zx according to claim 1, wherein the measurement of the stray induction is derived from an output voltage Ub delivered across a second secondary winding of Na coils of the single transformer and first integrated then successively subject to a comparison with a determined threshold and to a low-pass filtering.

3. The method for measuring a loop impedance Zx according to claim 1 or 2, wherein the comparison consists in determining the duration during which the output voltage Ub is positive and the duration during which it is negative.

4. A single-torus ohmmeter for measuring a loop impedance Zx, including a single transformer having a primary winding of Np coils (14) and a secondary winding of a single coil (16) forming a measurement loop of impedance Zx, **characterized in that**, to compensate for a stray induction produced by a DC leakage current circulating in the measurement loop without canceling a measurement current Ip generating an alternating induction of constant average value for the measurement of the loop impedance Zx, the transformer includes a second secondary winding of Na coils (18) whose output voltage Ub is delivered to a processing module (30 - 40) providing a voltage intended to be added to an alternating measurement voltage Vp in an adder (22) delivering the current to be injected into the primary winding (14) after passage through a voltage-current converter (20) supplying current to the primary winding via a shunt resistance (19).

5. The single-torus ohmmeter according to claim 4, wherein the module for processing the output voltage of the second secondary winding (18) consists of an integrator (40) followed by a comparator with a determined threshold (38) and by a low-pass filter (36), the voltage-current converter (20) and the value of the shunt resistance (19) being chosen so that the number of ampere-turns provided by the primary winding (14) to a magnetic core (12) of the single transformer is equal to the number of ampere-turns provided to this magnetic core by the single-coil secondary winding (16).

6. The single-torus ohmmeter according to claim 4, wherein the module for processing the output voltage of the second secondary winding (18) consists of an integrator (40) followed by a comparator with a determined threshold (38) and by a low-pass filter (36) whose output voltage is corrected in a digital correction module (30, 32, 34).

7. The single-torus ohmmeter according to claim 6, wherein the digital correction module consists of a microcontroller (32) preceded by an analog-to-digital converter (ADC 34) and followed by a digital-to-analog converter (DAC 30).

8. The single-torus ohmmeter according to claim 5 or 6, wherein the comparator is configured to determine the duration during which the output voltage Ub is positive and the duration during which it is negative.

9. The single-torus ohmmeter according to any one of claims 4 to 8, wherein the ratio between the number of coils Np of the primary winding (14) and the number of coils Na of the second secondary winding (18) is equal to one.

10. The single-torus ohmmeter according to any one of claims 4 to 9, wherein the transformer is made in the form of a non-opening magnetic sensor left permanently on a ground connection conductor and the loop impedance Zx is transmitted periodically to a remote server (54) via at least one communication network (52).
